(19) Europäisches Patentamt
European Patent Office
Office européen des brevets

(11) **EP 4 697 382 A1**

(12) **EUROPEAN PATENT APPLICATION**
published in accordance with Art. 153(4) EPC

(43) Date of publication:
**18.02.2026 Bulletin 2026/08**

(21) Application number: 24788479.4

(22) Date of filing: 08.03.2024

(51) International Patent Classification (IPC):
*H01L 27/146* (2006.01)     *H04N 25/70* (2023.01)
*H10K 30/20* (2023.01)      *H10K 30/60* (2023.01)
*H10K 39/32* (2026.01)

(52) Cooperative Patent Classification (CPC):
**H04N 25/70; H10F 39/12; H10K 30/20;
H10K 30/60; H10K 39/32**

(86) International application number:
**PCT/JP2024/008995**

(87) International publication number:
**WO 2024/214449 (17.10.2024 Gazette 2024/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.04.2023 JP 2023065809**

(71) Applicant: **Panasonic Intellectual Property
Management Co., Ltd.
Kadoma-shi, Osaka 571-0057 (JP)**

(72) Inventors:
• **MITSUISHI Morio**
  **Kadoma-shi, Osaka 571-0057 (JP)**
• **IIJIMA Hiroaki**
  **Kadoma-shi, Osaka 571-0057 (JP)**
• **MOMOSE Tatsunori**
  **Kadoma-shi, Osaka 571-0057 (JP)**

(74) Representative: **Grünecker Patent- und
Rechtsanwälte
PartG mbB
Leopoldstraße 4
80802 München (DE)**

(54) **IMAGING DEVICE**

(57)     An imaging device includes pixels (24) each including a photoelectric converter (10A) and a charge accumulation region. The photoelectric converter (10A) includes a lower electrode (2), an upper electrode (5), and a photoelectric conversion layer (4) that is positioned between the lower electrode (2) and the upper electrode (5) and generates electrons and holes by absorbing light. The charge accumulation region is electrically connected to the lower electrode (2) and accumulates signal charges that are either electrons or holes. When a predetermined bias voltage is applied between the lower electrode (2) and the upper electrode (5), $(C2 - C1)/C1 \le 0.2$ is satisfied, where C1 is a capacitance of the photoelectric converter (10A) in a state in which the photoelectric converter (10A) is not irradiated with light, and C2 is the capacitance of the photoelectric converter (10A) in a state in which the photoelectric converter (10A) is irradiated with light and the photoelectric converter (10A) is saturated with electrons and holes.

FIG. 5

EP 4 697 382 A1

## Description

Technical Field

The present disclosure relates to an imaging device.

Background Art

Stacked imaging devices have been proposed as metal oxide semiconductor (MOS) imaging devices. In the stacked imaging devices, a photoelectric conversion element including a photoelectric conversion layer is stacked above a semiconductor substrate, and charges generated by photoelectric conversion in the photoelectric conversion layer are collected by an electrode and accumulated in a charge accumulation region. For example, PTLS 1 and 2 each disclose a stacked imaging device that reads out accumulated charges by using a charge coupled device (CCD) circuit or a complementary MOS (CMOS) circuit in a semiconductor substrate.

Citation List

Patent Literature

PTL 1: Japanese Unexamined Patent Application Publication No. 2007-311647
PTL 2: Japanese Unexamined Patent Application Publication No. 2012-94660

Summary of Invention

Technical Problem

Imaging devices are used in various environments. For example, regarding an imaging device for monitoring or for a vehicle, which is used in an imaging environment in which brightness changes considerably, it is required that the imaging device perform high-quality imaging irrespective of the imaging environment. In the performance of an imaging device, the signal-to-noise ratio (S/N) performance is important in order to perform high-quality imaging. For example, it becomes possible to perform high-quality imaging by improving the S/N performance. The existing imaging devices described above have room for improvement in improving the S/N performance.

The present disclosure provides an imaging device that can improve the S/N performance.

An imaging device according to an aspect of the present disclosure includes pixels. Each of the pixels includes a photoelectric conversion element and a charge accumulation region. The photoelectric conversion element includes a first electrode, a second electrode that is disposed to face the first electrode, and a photoelectric conversion layer that is positioned between the first electrode and the second electrode, includes a donor semiconductor material and an acceptor semiconductor material, and generates electrons and holes by absorbing light. The charge accumulation region is electrically connected to the first electrode and accumulates signal charges that are either the electrons or the holes. When a predetermined bias voltage is applied between the first electrode and the second electrode, $(C2 - C1)/C1 \leq 0.2$ is satisfied, where C1 is a capacitance of the photoelectric conversion element in a state in which the photoelectric conversion element is not irradiated with light, and C2 is the capacitance of the photoelectric conversion element in a state in which the photoelectric conversion element is irradiated with light and the photoelectric conversion element is saturated with the electrons and the holes.

With the present disclosure, it is possible to provide an imaging device that can improve the S/N performance.

Brief Description of Drawings

[Fig. 1] Fig. 1 is a schematic sectional view illustrating the configuration of a photoelectric conversion element according to an embodiment.
[Fig. 2] Fig. 2 is an exemplary energy band diagram of the photoelectric conversion element according to the embodiment.
[Fig.3] Fig. 3 is a schematic sectional view illustrating the configuration of another photoelectric conversion element according to the embodiment.
[Fig. 4] Fig. 4 illustrates an example of the circuit configuration of an imaging device according to an embodiment.
[Fig. 5] Fig. 5 is a schematic sectional view illustrating the device structure of a pixel of the imaging device according to the embodiment.
[Fig. 6] Fig. 6 is an exemplary energy band diagram of a photoelectric converter when a first bias voltage is applied between a lower electrode and an upper electrode.
[Fig. 7] Fig. 7 is an exemplary energy band diagram of the photoelectric converter when a second bias voltage is applied between the lower electrode and the upper electrode.
[Fig. 8] Fig. 8 is a graph schematically illustrating an example of the capacitance-voltage characteristics (C-V characteristics) of the photoelectric converter according to the present embodiment.
[Fig. 9] Fig. 9 is a graph conceptually illustrating the distribution of the quantity of charges accumulated in the photoelectric converter.
[Fig. 10] Fig. 10 is a graph schematically illustrating an example of the capacitance-voltage characteristics (C-V characteristics) of a photoelectric converter according to Comparative Example.

[Fig. 11] Fig. 11 is a graph illustrating the relationship between (C2 - C1)/C1 and the S/N of imaging devices according to Examples and Comparative Examples. Description of Embodiments

(Underlying Knowledge Forming Basis of the Present Disclosure)

The inventors have found that it is necessary to address the following problems in order to provide an imaging device that can improve the S/N performance.

In an imaging device using a photoelectric conversion element, when the photoelectric conversion element is irradiated with light, pairs of electrons and holes are generated. In accordance with a bias voltage applied between a pair of electrodes of the photoelectric conversion element, the electrons and holes are extracted to these electrodes, and either the electrons or the holes are accumulated in a charge accumulation region as signal charges. On the other hand, not all of the charges generated in the photoelectric conversion element are extracted to the electrodes. In the photoelectric conversion element, a trap level, which traps the electrons or holes and restricts movement of the trapped electrons or holes, and an interface between different materials, which is a barrier for movement of the electrons or holes, exist. As a result, some of the charges generated by the photoelectric conversion element accumulate in the photoelectric conversion element. When the quantity of charges accumulated in the photoelectric conversion element is large, the dispersion of the quantity of charges is also large. In particular, when the photoelectric conversion element is irradiated with light, pairs of electrons and holes are generated, and thus the quantity of charges accumulated in the photoelectric conversion element increases. In the imaging device, because one of the pair of electrodes of the photoelectric conversion element is electrically connected to the charge accumulation region, the dispersion of the quantity of charges accumulated in the photoelectric conversion element influences the charge accumulation region and becomes a factor in generation of noise in the imaging device.

The present disclosure has been made against the above background and provides an imaging device that can improve the S/N performance by suppressing increase in the quantity of charges accumulated in a photoelectric conversion element when the photoelectric conversion element is irradiated with light.

(Overview of Present Disclosure)

As an outline of an aspect of the present disclosure, examples of an imaging device according to the present disclosure will be described below.

An imaging device according to a first aspect of the present disclosure includes pixels. Each of the pixels includes a photoelectric conversion element and a charge accumulation region. The photoelectric conversion element includes a first electrode, a second electrode that is disposed to face the first electrode, and a photoelectric conversion layer that is positioned between the first electrode and the second electrode, includes a donor semiconductor material and an acceptor semiconductor material, and generates electrons and holes by absorbing light. The charge accumulation region is electrically connected to the first electrode and accumulates signal charges that are either the electrons or the holes. When a predetermined bias voltage is applied between the first electrode and the second electrode, $(C2 - C1)/C1 \leq 0.2$ is satisfied, where C1 is a capacitance of the photoelectric conversion element in a state in which the photoelectric conversion element is not irradiated with light, and C2 is the capacitance of the photoelectric conversion element in a state in which the photoelectric conversion element is irradiated with light and the photoelectric conversion element is saturated with the electrons and the holes.

With the configuration according to the present aspect, increase in noise is suppressed even when the photoelectric conversion element is irradiated with light, and the S/N performance can be improved.

To be specific, noise can be reduced by reducing increase in the quantity of charges accumulated in the photoelectric conversion element due to irradiation of the photoelectric conversion element with light. Because the quantity of charges accumulated in photoelectric conversion element is correlated to the capacitance of the photoelectric conversion element, when the relationship between the capacitance C1 and the capacitance C2 is $(C2 - C1)/C1 \leq 0.2$, sufficient noise reduction can be realized, and the S/N performance can be improved.

For example, an imaging device according to a second aspect of the present disclosure is the imaging device according to the first aspect, in which, between the first electrode and the second electrode, a first bias voltage is applied in a first period that is an exposure period, and a second bias voltage that is different from the first bias voltage is applied in a second period that is a non-exposure period.

Thus, even when different bias voltages are applied between the first electrode and the second electrode in the exposure period and the non-exposure period, the S/N performance can be improved as described above.

For example, an imaging device according to a third aspect of the present disclosure is the imaging device according to the second aspect, in which a photoelectric conversion efficiency of the photoelectric conversion element in the first period is different from the photoelectric conversion efficiency of the photoelectric conversion element in the second period.

Thus, even when the first bias voltage and the second bias voltage, which are different in the change in the quantity of charges that are generated in accordance with the intensity of light that enters the photoelectric conversion element, are applied between the first electrode and the second electrode in the first period and the second period, the S/N performance of the imaging device can be improved as described above.

For example, an imaging device according to a fourth aspect of the present disclosure is the imaging device according to the second or third aspect, in which the imaging device operates by using a global shutter method in which all exposure periods of the pixels are the same, and the first period is a period for accumulating the signal charges in the charge accumulation region.

Thus, because it is possible to expose all pixels to light at the same timing, improvement of the S/N performance can be realized while suppressing occurrence of a phenomenon, such as distortion of an image, that is peculiar to a rolling shutter.

For example, an imaging device according to a fifth aspect of the present disclosure is the imaging device according to the fourth aspect, in which the electrons and the holes in the photoelectric conversion layer recombine when the second bias voltage is applied between the first electrode and the second electrode.

In this way, because the second bias voltage that causes electrons and holes to recombine is supplied in the second period, by using the second period, which is a non-exposure period, as a signal readout period, the quantity of charges that are extracted from the photoelectric conversion layer to the first electrode in the non-exposure period decreases.

For example, an imaging device according to a sixth aspect of the present disclosure is the imaging device according to the fourth or fifth aspect, in which the photoelectric conversion layer has photoelectric conversion sensitivity when the first bias voltage is applied between the first electrode and the second electrode.

In this way, because the first bias voltage with which the photoelectric conversion layer has sensitivity is supplied in the first period, which is an exposure period, imaging can be performed by using a global shutter method.

For example, an imaging device according to a seventh aspect of the present disclosure is the imaging device according to any one of the first to sixth aspects, further including a voltage supply circuit that selectively applies, between the first electrode and the second electrode, a bias voltage such that a potential of the second electrode relative to the first electrode becomes a positive potential and a bias voltage such that the potential of the second electrode relative to the first electrode becomes a negative potential.

In this way, even when a bias voltage such that the potential of the second electrode relative to the first electrode becomes a positive potential or a negative potential is applied between the first electrode and the second electrode, the S/N performance of the imaging device can be improved.

For example, an imaging device according to an eighth aspect of the present disclosure is the imaging device according to any one of the first to seventh aspects, in which the photoelectric conversion element further includes a first charge blocking layer that is positioned between the first electrode and the photoelectric conversion layer.

Thus, it is possible to suppress a leakage current from the first electrode to the photoelectric conversion layer.

For example, an imaging device according to a ninth aspect of the present disclosure is the imaging device according to the eighth aspect, in which a thickness of the first charge blocking layer is greater than or equal to 10 nm.

Thus, it is possible to enhance the effect of suppressing a leakage current from the first electrode to the photoelectric conversion layer.

For example, an imaging device according to a tenth aspect of the present disclosure is the imaging device according to any one of the first to ninth aspects, in which the photoelectric conversion element further includes a second charge blocking layer that is positioned between the second electrode and the photoelectric conversion layer.

Thus, it is possible to suppress a leakage current from the second electrode to the photoelectric conversion layer.

For example, an imaging device according to an eleventh tenth aspect of the present disclosure is the imaging device according to the tenth aspect, in which a thickness of the second charge blocking layer is greater than or equal to 5 nm.

Thus, it is possible to enhance the effect of suppressing a leakage current from the second electrode to the photoelectric conversion layer.

Hereafter, embodiments will be described with reference to the drawings.

The embodiments described below each represent a general or specific example. The values, shapes, constituent elements, arrangements of constituent elements, positions and connection configurations of constituent elements, steps, order of steps, and the like described in the following embodiments are examples, and do not limit the present disclosure. Among the constituent elements in the embodiments, constituent elements that are not described in the independent claims are optional constituent elements. Each figure is not necessarily drawn strictly. In the figures, substantially the same configurations are denoted by the same numerals, and redundant descriptions thereof may be omitted or simplified.

In the present specification, terms that represent the relationships between elements such as "perpendicular", terms that represent the shapes of elements such as "rectangular", and numerical ranges not only have strict meanings but also have substantially equivalent meanings.

In the present specification, the terms "above" and "below" do not represent the upward direction (vertically above) and the downward direction (vertically below) in absolute spatial recognition, but are used as terms that are defined by a relative positional relationship based on the stacked order in a stacked configuration. The terms "above" and "below" are only used to specify relative arrangement of members and do not limit the position of an imaging device when the imaging device is used. The terms "above" and "below" are used, not only when two constituent elements are disposed with a space therebetween and another constituent element is present between the two constituent elements, but also when two constituent elements are disposed very close to each other and the two constituent elements are in close contact with each other.

In the present specification, for convenience, the term "light" refers to electromagnetic radiation in general, including visible light, infrared radiation, and ultraviolet radiation.

(Embodiments)

Hereafter, the present embodiment will be described.

[Photoelectric Conversion Element]

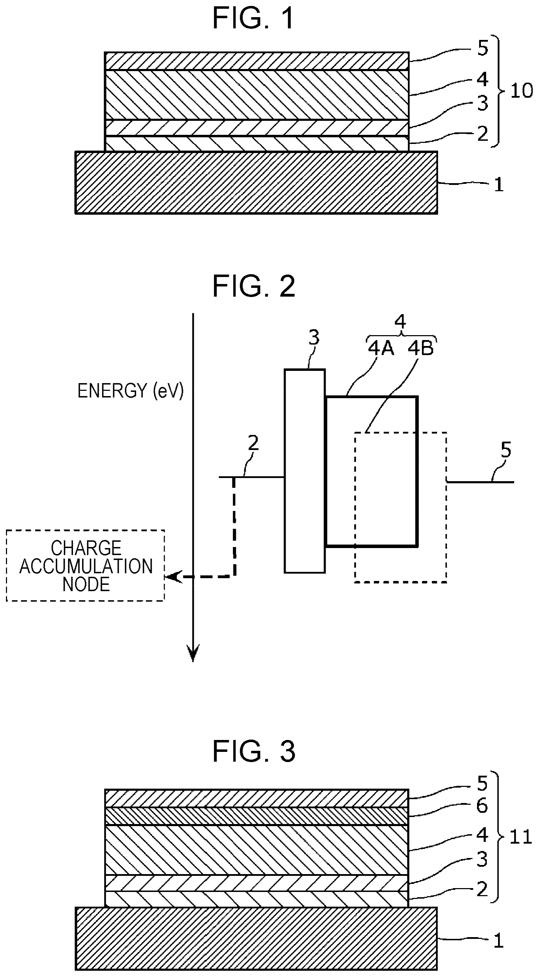

First, referring to Fig. 1, a photoelectric conversion element included in an imaging device according to the present embodiment will be described. The photoelectric conversion element according to the present embodiment is a charge-readout photoelectric conversion element. Fig. 1 is a schematic sectional view illustrating the configuration of a photoelectric conversion element 10 according to the present embodiment.

As illustrated in Fig. 1, the photoelectric conversion element 10 is supported by a support substrate 1, and includes an upper electrode 5 and a lower electrode 2 that are a pair of electrodes, a photoelectric conversion layer 4 between the upper electrode 5 and the lower electrode 2, and a charge blocking layer 3 positioned between the lower electrode 2 and the photoelectric conversion layer 4. In the present embodiment, the lower electrode 2 is an example of a first electrode, and the upper electrode 5 is an example of a second electrode. The charge blocking layer 3 is an example of a first charge blocking layer.

The photoelectric conversion element 10 is used, for example, in a position such that light that has passed through the upper electrode 5 enters the photoelectric conversion layer 4.

Hereafter, each constituent element of the photoelectric conversion element 10 according to the present embodiment will be described.

The support substrate 1 may be any substrate that is used to support a general photoelectric conversion element, and may be, for example, a glass substrate, a quartz substrate, a semiconductor substrate, a plastic substrate, or the like.

The lower electrode 2 and the upper electrode 5 are film-like electrodes that are disposed to face each other.

The lower electrode 2 collects signal charges generated by the photoelectric conversion layer 4. The lower electrode 2 is made of a metal, a metal nitride, a metal oxide, a polysilicon having electroconductivity, or the like. Examples of the metal include aluminum, copper, titanium, and tungsten. Examples of a method for providing a polysilicon with electroconductivity include doping the polysilicon with an impurity.

The upper electrode 5 is disposed to face the lower electrode 2 with the photoelectric conversion layer 4 therebetween. The upper electrode 5 is, for example, a transparent electrode made from a transparent electroconductive material. Examples of the material of the upper electrode 5 include transparent conducting oxide (TCO), indium tin oxide (ITO), indium zinc oxide (IZO), aluminum-doped zinc oxide (AZO), fluorine-doped tin oxide (FTO), $SnO_2$, and $TiO_2$. In accordance with a desirable transmittance, the upper electrode 5 may be made from TCO, a metal material such as aluminum (Al) or gold (Au), or a combination of such metal materials.

The materials of the lower electrode 2 and the upper electrode 5 are not limited to the electroconductive materials described above, and may be other materials. For example, the lower electrode 2 may be a transparent electrode.

Various methods are used to make the lower electrode 2 and the upper electrode 5 in accordance with the materials used. For example, when ITO is used, an electron beam method, a sputtering method, a resistance-heating deposition method, a chemical reaction method such as a sol-gel method, an indium-tin-oxide dispersion application method, or the like may be used. In this case, after an ITO film has been formed, UV-ozone processing, plasma processing, or the like may be additionally performed to make the lower electrode 2 and the upper electrode 5.

In the present embodiment, the upper electrode 5 may be an ITO film that is formed in a deposition atmosphere in which the oxygen concentration in a deposition gas is less than equal to 0.12%.

For example, when an ITO film is to be formed by using a sputtering method, the target composition ratio is, for example, InO:SnO = 90:10. However, the target composition ratio may be InO:SnO = 95:5, or may be another ratio. The ITO film is formed, for example, in a chamber of a deposition atmosphere into which a deposition gas adjusted to have a predetermined oxygen concentration has been introduced. To adjust the deposition atmosphere for the ITO film, a deposition gas including only argon or a deposition gas in which argon and oxygen are mixed and the oxygen centration is adjusted may be introduced into the chamber, or argon and oxygen, as necessary, may be independently introduced into the chamber. The pressure in the chamber is, for example, 0.3 Pa, or may have another value.

By forming an ITO film on the photoelectric conversion layer 4 by using a deposition gas in which the oxygen concentration is less than or equal to 0.12%, the amount of oxygen to which the photoelectric conversion layer 4 is exposed when the ITO film is being formed is reduced, and generation of a trap level in the photoelectric conversion layer 4 can be suppressed. In the present specification, the meaning of the expression "the oxygen concentration in the deposition gas is less than or equal to 0.12%" includes a meaning that the oxygen concentration is 0%, that is, oxygen is not included in the deposition gas.

The photoelectric conversion layer 4 generates electrons and holes by absorbing light. Either the electrons or the holes are used as signal charges. That is, the photoelectric conversion layer 4 converts light into signal charges.

The photoelectric conversion layer 4 includes, for example, a donor semiconductor material and an acceptor semiconductor material. The photoelectric conversion layer 4 is made by using, for example, an organic semiconductor material. As a method of making the photoelectric conversion layer 4, it is possible to use, for example, a wet method such as an application method by spin coating or a dry method such as a vapor deposition method. A vapor deposition method is a method with which the material of a layer is evaporated and deposited on a substrate by heating the material in vacuum. It is also possible to make the charge blocking layer 3 by using a method similar to a method of making the photoelectric conversion layer 4.

The photoelectric conversion layer 4 is, for example, a mixture film having a bulk-hetero structure and including a donor semiconductor material such as a donor organic semiconductor material and an acceptor semiconductor material such as an acceptor organic semiconductor material. The photoelectric conversion layer 4 may have a stacked structure in which a layer of a donor semiconductor material and a layer of an acceptor semiconductor material are stacked.

The photoelectric conversion layer 4 can be easily formed as a thin film by including a donor organic semiconductor material and an acceptor organic semiconductor material. Hereafter, specific examples of a donor organic semiconductor material and an acceptor organic semiconductor material will be listed.

Examples of a donor organic semiconductor material include triarylamine compounds, benzidine compounds, pyrazoline compounds, styrylamine compounds, hydrazone compounds, triphenylmethane compounds, carbazole compounds, polysilane compounds, thiophene compounds, phthalocyanine compounds, naphthalocyanine compounds, subphthalocyanine compounds, cyanine compounds, merocyanine compounds, oxonol compounds, polyamine compounds, indole compounds, pyrrole compounds, pyrazole compounds, biphenyl compounds, terphenyl compounds, polyarylene compounds, fused aromatic carbocyclic compounds, and metal complexes including a nitrogen-containing heterocyclic compound as a ligand.

Examples of fused aromatic carbocyclic compounds include naphthalene derivatives, anthracene derivatives, phenanthrene derivatives, tetracene derivatives, pyrene derivatives, perylene derivatives, and fluoranthene derivatives.

Examples of an acceptor organic semiconductor material include fullerenes; fullerene derivatives; fused aromatic carbocyclic compounds; 5- to 7-membered heterocyclic compounds containing a nitrogen atom, an oxygen atom, or a sulfur atom; polyarylene compounds; fluorene compounds; cyclopentadiene compounds; silyl compounds; and metal complexes including a nitrogen-containing heterocyclic compound as a ligand.

Examples of fullerenes include C60 fullerene and C70 fullerene.

Examples of fullerene derivatives include phenyl C61 butyric acid methyl ester (PCBM) and indene-C60 bisadduct (ICBA).

Examples of 5- to 7-membered heterocyclic compounds containing a nitrogen atom, an oxygen atom, or a sulfur atom include: pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzoxazole, benzothiazole, carbazole, purine, triazolopyridazine, triazolopyrimidine, tetrazaindene, oxadiazole, imidazopyridine, pyrrolidine, pyrrolopyridine, thiadiazolopyridine, dibenzazepine, and tribenzazepine.

A donor organic semiconductor material and an acceptor organic semiconductor material are not limited to the above examples. Any low-molecular-weight or high-molecular-weight organic compound may be used as a donor organic semiconductor material or an acceptor organic semiconductor material of the photoelectric conversion layer 4, as long as the organic compound can be formed into a photoelectric conversion layer by using either a dry method or a wet method.

The photoelectric conversion layer 4 may include a material other than an organic semiconductor material as a donor semiconductor material or an acceptor semiconductor material. The photoelectric conversion layer 4 may include, as a semiconductor material, a silicon semiconductor, a compound semiconductor, quantum dots, a perovskite material, carbon nanotubes, or a mixture of two or more of these.

As described above, the photoelectric conversion element 10 according to the present embodiment includes the charge blocking layer 3 between the lower electrode 2 and the photoelectric conversion layer 4. The charge blocking layer 3 is, for example, in contact with the lower electrode 2 and the photoelectric conversion layer 4.

The charge blocking layer 3 includes, for example, a first semiconductor material. The first semiconductor material is, for example, an organic semiconductor material. The organic semiconductor material is, for example, the aforementioned donor organic semiconductor material or acceptor organic semiconductor material. The first semiconductor material of the charge blocking layer 3 is not limited to an organic semiconductor material, may be an oxide semiconductor, a nitride semiconductor, or the like, or may be a composite material of these. The material of the charge blocking layer 3 may be, for example, a metal oxide such as aluminum oxide.

The charge blocking layer 3 may have a structure in which layers are stacked. In this case, the materials of the layers may be the same, or may be different from each other.

The thickness of the charge blocking layer 3 is, for example, greater than or equal to 10 nm. In view of effective suppression of dark current and noise, the thickness of the charge blocking layer 3 may be greater than or equal to 20 nm or may be greater than or equal to 50 nm. In view of suppression of decrease of sensitivity, the thickness of the charge blocking layer 3 may be less than or equal to 1000 nm or may be less than or equal to 600 nm.

Fig. 2 is an exemplary energy band diagram of the photoelectric conversion element illustrated in Fig. 1. In Fig. 2, the energy band of each layer is represented by a rectangle.

When irradiated with light, the photoelectric conversion layer 4 generates excitons therein. The generated excitons diffuse in the photoelectric conversion layer 4 and are separated into electrons and holes at the interface between an acceptor semiconductor material and a donor semiconductor material. When a voltage is applied between the upper electrode 5 and the lower electrode 2 so that the potential of the upper electrode 5 becomes higher than the potential of the lower electrode 2, electrons move toward the upper electrode 5 and holes move toward the lower electrode 2. When the photoelectric conversion element 10 is used for an imaging device, for example, holes are collected by the lower electrode 2 and are accumulated as signal charges in a charge accumulation node that is electrically connected to the lower electrode 2. The charge accumulation node is an example of a charge accumulation region that accumulates signal charges collected by the lower electrode 2. In this way, the photoelectric conversion layer 4 converts light into signal charges, and the lower electrode 2 collects signal charges generated by the photoelectric conversion layer 4. The upper electrode 5 collects charges whose polarity is opposite to that of signal charges. Hereafter, a case where holes moves toward the lower electrode 2 and holes are used as signal charges will be described. However, electrons may be used as signal charges. In this case, a voltage is applied between the upper electrode 5 and the lower electrode 2 so that the potential of the upper electrode 5 becomes lower than the potential of the lower electrode 2, holes move toward the upper electrode 5, and electrons move toward the lower electrode 2.

Here, the term "doner material" refers to a material that provides electrons, among the pairs of electrons and holes generated by absorbing light, to another material, and the term "acceptor material" refers to the other material that accepts the electrons. In the present embodiment, the donor semiconductor material is a doner material, and the acceptor semiconductor material is an acceptor material. When two different organic semiconductor materials are used, which of these is a doner material and which of these is an acceptor material is determined by the relative positions of the energy levels of highest-occupied-molecular-orbital (HOMO) and lowest-unoccupied-molecular-orbital (LUMO) of the two organic semiconductor materials at the contact interface. In Fig. 2, in each rectangle representing the energy band, the upper end is the energy level of LUMO and the lower end is the energy level of HOMO. The energy difference between the vacuum level and the energy level of LUMO is called the electron affinity. The energy difference between the vacuum level and the energy level of HOMO is called the ionization potential. In Fig. 2, the lower the position, the greater the electron affinity and the ionization potential. The same applies to energy band diagrams described below.

As illustrated in Fig. 2, among the two semiconductor materials included in the photoelectric conversion layer 4, a material whose energy level of LUMO is shallower, that is, the electron affinity is smaller, is a donor semiconductor material 4A that is a doner material. Among the two semiconductor materials included in the photoelectric conversion layer 4, a material whose energy level of LUMO is deeper, that is, the electron affinity is greater, is an acceptor semiconductor material 4B that is an acceptor material. In Fig. 2, the energy band of the donor semiconductor material 4A and the energy band of the acceptor semiconductor material 4B are illustrated to be displaced in the horizontal direction. However, this is for viewability, and does not mean that the donor semiconductor material 4A and the acceptor semiconductor material 4B are distributed separately in the thickness direction of the photoelectric conversion layer 4. The energy band of the acceptor semiconductor material 4B is represented by a broken-line rectangle. However, this is also for viewability, and it is not intended to discriminate a broken-line rectangle from a solid-line rectangle. The same applies to energy band diagrams described below.

The ionization potential of the donor semiconductor material 4A is, for example, less than the ionization potential of the acceptor semiconductor material 4B.

In Fig. 2, the electron affinity and the ionization potential of the charge blocking layer 3 are, for example, the electron affinity and the ionization potential of the first semiconductor material included in the charge blocking layer 3.

The charge blocking layer 3 is configured to transport signal charges and to block charges whose polarity is opposite to that of signal charges. As illustrated in Fig. 2, when holes are used as signal charges, the electron affinity of the charge blocking layer 3 is, for example, less than or equal to the electron affinity of the acceptor semiconductor material 4B of the photoelectric conversion layer 4. Moreover, the electron affinity of the charge blocking layer 3 is less than the work function of the lower electrode 2. Thus, the charge blocking layer 3 suppresses injection of charges (to be specific, electrons) whose polarity is opposite to that of signal charges from the lower electrode 2 to the photoelectric conversion layer 4. As a result, it is possible to reduce noise signals due to dark current, which negatively influence the S/N. When the charge blocking layer 3 has a structure in which layers are stacked, the electron affinity of at least one of the layers is less than or equal to the electron affinity of the acceptor semiconductor material 4B of the photoelectric conversion layer 4 and is less than the work function of the lower electrode 2.

For example, the difference between the ionization potential of the charge blocking layer 3 and the ionization potential of the donor semiconductor material 4A of the photoelectric conversion layer 4 is less than or equal to 1 eV. Thus, signal charges can be easily transported in the charge blocking layer 3, and the efficiency of the lower electrode 2 in extracting signal charges generated by the photoelectric conversion layer 4 improves. When the charge blocking layer 3 has a structure in which layers are stacked, for example, the difference between the ionization potential of any of the layers and the ionization potential of the donor semiconductor material 4A is less than or equal to 1 eV.

When electrons are used as signal charges, in order to suppress injection of holes from the lower electrode 2 to the photoelectric conversion layer 4, the ionization potential of the charge blocking layer 3 is, for example, greater than or equal to the ionization potential of the donor semiconductor material 4A of the photoelectric conversion layer 4. When electrons are used as signal charges, the ionization potential of the charge blocking layer 3 is greater than the work function of the lower electrode 2.

When electrons are used as signal charges, the difference between the electron affinity of the charge blocking layer 3 and the electron affinity of the acceptor semiconductor material 4B is less than or equal to 1 eV. Thus, the efficiency of the lower electrode 2 in extracting signal charges (to be specific, electrons) improves.

[Another Example of Photoelectric Conversion Element]

A photoelectric conversion element according to the present embodiment may further includes a charge blocking layer also between the upper electrode 5 and the photoelectric conversion layer 4. Fig. 3 is a schematic sectional view illustrating the configuration of another photoelectric conversion element 11 according to the present embodiment. As illustrated in Fig. 3, the photoelectric conversion element 11 further includes, in addition to the configuration of the photoelectric conversion element 10, a charge blocking layer 6 between the upper electrode 5 and the photoelectric conversion layer 4. The charge blocking layer 6 is, for example, in contact with the upper electrode 5 and the photoelectric conversion layer 4. The charge blocking layer 6 is an example of a second charge blocking layer.

The charge blocking layer 6 includes, for example, a second semiconductor material. The second semiconductor material is, for example, an organic semiconductor material. The organic semiconductor material is, for example, the aforementioned donor organic semiconductor material or acceptor organic semiconductor material. The second semiconductor material of the charge blocking layer 6 is not limited to an organic semiconductor material, may be an oxide semiconductor, a nitride semiconductor, or the like, or may be a composite material of these. The material of the charge blocking layer 6 may be, for example, a metal oxide such as aluminum oxide. The charge blocking layer 6 may include the same material as the charge blocking layer 3. The charge blocking layer 6 may include a material that is the same as a donor semiconductor material included in the photoelectric conversion layer 4.

The charge blocking layer 6 may have a structure in which layers are stacked. In this case, the materials of the layers may be the same, or may be different from each other.

The charge blocking layer 6 is configured to transport charges whose polarity is opposite to that of signal charges and to block signal charges. When holes are used as signal charges, the ionization potential of the charge blocking layer 6 is, for example, greater than or equal to the ionization potential of the donor semiconductor material 4A of the photoelectric conversion layer 4. The ionization potential of the charge blocking layer 6 is greater than the work function of the upper electrode 5. Thus, the charge blocking layer 6 suppresses injection of signal charges (to be specific, holes) from the upper electrode 5 to the photoelectric conversion layer 4. As a result, it is possible to reduce noise signals due to dark current, which negatively influence the S/N. When the charge blocking layer 6 has a structure in which layers are stacked, the ionization potential of at least one of the layers is greater than or equal to the ionization potential of the donor semiconductor material 4A of the photoelectric conversion layer 4 and is greater than the work function of the upper electrode 5.

For example, the difference between the electron affinity of the charge blocking layer 6 and the electron affinity of the acceptor semiconductor material 4B of the photoelectric conversion layer 4 is less than or equal to 1 eV. Thus, the efficiency in transporting charges (to be specific, electrons) whose polarity is opposite to that of signal charges to the upper electrode 5 improves. When the charge blocking layer 6 has a structure in which layers are stacked, for example, the difference between the electron affinity of any of the layers and the electron affinity of the acceptor semiconductor material 4B is less than or equal to 1 eV.

The electron affinity and the ionization potential of the charge blocking layer 6 are, for example, the electron affinity and the ionization potential of the second semiconductor material included in the charge blocking layer 6.

The thickness of the charge blocking layer 6 is, for example, greater than or equal to 5 nm. In view of effective suppression of dark current and noise, the thickness of the charge blocking layer 6 may be greater than or equal to 10 nm, may be greater than or equal to 20 nm, or may be greater than or equal to 30 nm. In view of suppression of decrease of sensitivity, the thickness of the charge blocking layer 6 may be less than or equal to 500 nm or may be less than or equal to 300 nm.

When electrons are used as signal charges, in order to suppress injection of electrons from the upper electrode 5 to the photoelectric conversion layer 4, the electron affinity of the charge blocking layer 6 is, for example, less than or equal to the electron affinity of the acceptor semiconductor material 4B of the photoelectric conversion layer 4. When electrons are used as signal charges, the electron affinity of the charge blocking layer 6 is less than the work function of the upper electrode 5.

When electrons are used as signal charges, the difference between the ionization potential of the charge blocking layer 6 and the ionization potential of the donor semiconductor material 4A is less than or equal to 1 eV. Thus, the efficiency in movement of charges (to be specific, holes) whose polarity is opposite to that of signal charges to the upper electrode 5 improves.

[Imaging Device]

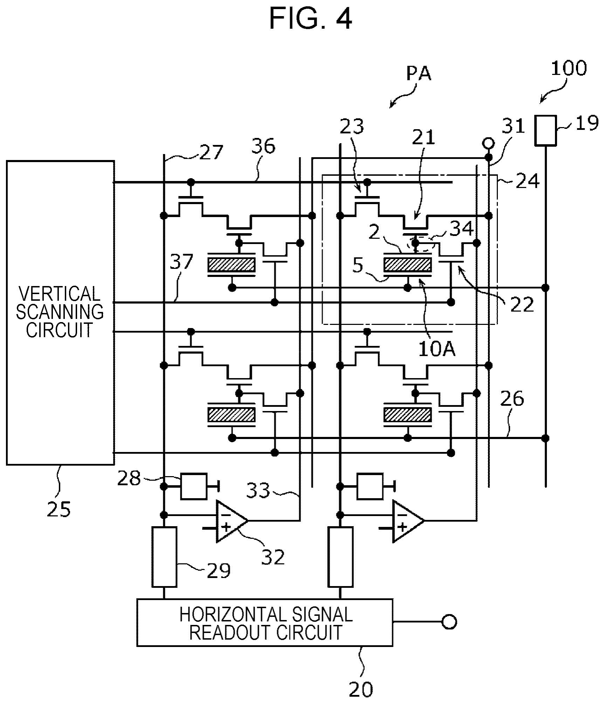

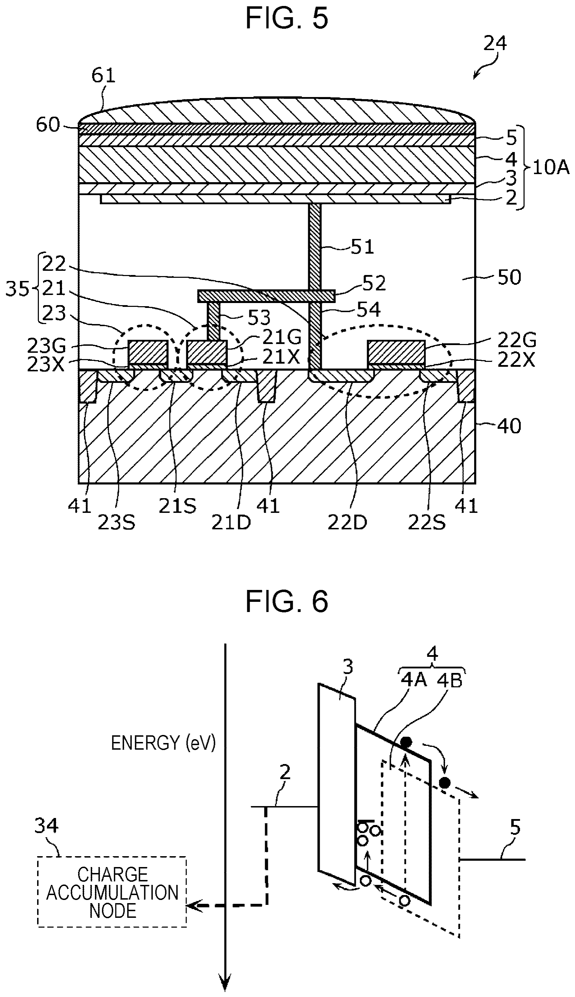

Next, referring to Figs. 4 and 5, an imaging device according to the present embodiment will be described. Fig. 4 illustrates an example of the circuit configuration of an imaging device 100 including a photoelectric converter 10A using the photoelectric conversion element 10 illustrated in Fig. 1. Fig. 5 is a schematic sectional view illustrating the device structure of a pixel 24 of the imaging device 100 according to the present embodiment.

As illustrated in Figs. 4 and 5, the imaging device 100 according to the present embodiment includes: a semiconductor substrate 40; and pixels 24 each including a charge detection circuit 35 provided at the semiconductor substrate 40, the photoelectric converter 10A provided above the semiconductor substrate 40, and a charge accumulation node 34 electrically connected to the charge detection circuit 35 and the photoelectric converter 10A. The photoelectric converter 10A of each pixel 24 includes the aforementioned photoelectric conversion element 10. That is, each pixel 24 includes the lower electrode 2, the upper electrode 5, the photoelectric conversion layer 4, and the charge blocking layer 3. In the present embodiment, the charge accumulation node 34 is an example of a charge accumulation region. The photoelectric converter 10A may include the photoelectric conversion element 11. That is, each pixel 24 may further include the charge blocking layer 6 in addition to the configuration described above.

In the photoelectric converter 10A, the upper electrode 5, the photoelectric conversion layer 4, the charge blocking layer 3, and the lower electrode 2 are arranged in this order from the side from which light enters the imaging device 100. In the present embodiment, light that has passed through the upper electrode 5 enters the photoelectric conversion layer 4. In the present embodiment, the side from which light enters the imaging device 100 is opposite from the semiconductor substrate 40 side of the photoelectric converter 10A. In the present embodiment, the side from which light enters is the upper side.

The charge accumulation node 34 accumulates signal charges generated by the photoelectric converter 10A, and the charge detection circuit 35 detects signal charges accumulated in the charge accumulation node 34. The charge detection circuit 35, which is provided at the semiconductor substrate 40, may be provided on the semiconductor substrate 40, or may be directly provided in the semiconductor substrate 40.

As illustrated in Fig. 4, the imaging device 100 includes the pixels 24 and peripheral circuits. The imaging device 100 is, for example, an image sensor implemented in a one-chip integrated circuit, and includes a pixel array PA including the pixels 24 that are arranged two-dimensionally.

The pixels 24 are arranged on the semiconductor substrate 40 two dimensionally, that is, in the row direction and the column direction, to form a photosensitive region that is a pixel region. Fig. 4 illustrates an example in which the pixels 24 are arranged in a 2×2 matrix pattern. The arrangement of the pixels 24 is not limited to 2×2, and the number of rows and the number of columns of the pixels 24 are not particularly limited. In Fig. 4, for convenience of illustration, illustration of a circuit (for example, a pixel electrode control circuit) for individually setting the sensitivities of the pixels 24 is omitted. The imaging device 100 may be a line sensor. In this case, the pixels 24 may be arranged one-dimensionally. In the present specification, the term "row direction" and the term "column direction" respectively refer to a direction in which rows extend and a direction in which columns extend. That is, in Fig. 4, the vertical direction in the plane of the figure is the column direction, and the horizontal direction in the plane of the figure is the row direction.

As illustrated in Figs. 4 and 5, each pixel 24 includes the photoelectric converter 10A, the charge detection circuit 35, and the charge accumulation node 34 electrically connected to the photoelectric converter 10A and the charge detection circuit 35. The charge detection circuit 35 includes an amplification transistor 21, a reset transistor 22, and an address transistor 23.

The photoelectric converter 10A includes the lower electrode 2, which is provided as a pixel electrode, and the upper electrode 5, which is provided as a counter electrode that faces the pixel electrode. It is not necessary that the entirety of the photoelectric converter 10A be an element that is independent for each pixel 24, and a part of the photoelectric converter 10A may be shared by two or more pixels 24. A voltage for applying a predetermined bias voltage is supplied to the upper electrode 5 via a counter electrode signal line 26.

The lower electrode 2 is connected to a gate electrode 21G of the amplification transistor 21, and signal charges collected by the lower electrode 2 are accumulated in the charge accumulation node 34 positioned between the lower electrode 2 and the gate electrode 21G of the amplification transistor 21. For example, when signal charges are holes, the charge accumulation node 34 is electrically connected to the lower electrode 2 and accumulates holes, among the excitons generated by the photoelectric conversion layer 4.

A voltage in accordance with the quantity of signal charges accumulated in the charge accumulation node 34 is applied to the gate electrode 21G of the amplification transistor 21. The amplification transistor 21 amplifies the voltage, and the address transistor 23 selectively reads out the voltage as a signal voltage. The reset transistor 22 has a source/drain electrode connected to the lower electrode 2 via the charge accumulation node 34, and resets signal charges accumulated in the charge accumulation node 34. In other words, the reset transistor 22 resets the potential of the gate electrode 21G of the amplification transistor 21 and the lower electrode 2.

In order to selectively perform the above operation in the pixels 24, the imaging device 100 includes a power source wiring line 31, a vertical signal line 27, an address signal line 36, and a reset signal line 37. These lines are connected to each pixel 24. To be specific, the power source wiring line 31 is connected to the source/-drain electrode of the amplification transistor 21, and the vertical signal line 27 is connected to the source/drain electrode of the address transistor 23. The address signal line 36 is connected to a gate electrode 23G of the address transistor 23. The reset signal line 37 is connected to the gate electrode 22G of the reset transistor 22.

The peripheral circuits include a voltage supply circuit 19, a vertical scanning circuit 25, a horizontal signal readout circuit 20, column signal processing circuits 29, load circuits 28, and differential amplifiers 32.

The voltage supply circuit 19 is electrically connected to the upper electrode 5 via the counter electrode signal line 26. By applying a voltage to the upper electrode 5, the voltage supply circuit 19 provides a potential difference between the upper electrode 5 and the lower electrode 2, that is, applies a voltage between the upper electrode 5 and the lower electrode 2. When the lower electrode 2 collects holes as signal charges, the voltage supply circuit 19 supplies, to the upper electrode 5, a voltage such that the potential of the upper electrode 5 becomes higher than the potential of the lower electrode 2. When the lower electrode 2 collects electrons as signal charges, the voltage supply circuit 19 supplies, to the upper electrode 5, a voltage such that the potential of the upper electrode 5 becomes lower than the potential of the lower electrode 2.

As described below in detail, the sensitivity of the photoelectric converter 10A is controlled by switching a voltage suppled from the voltage supply circuit 19 to the upper electrode 5 between voltages that are different from each other.

For example, the voltage supply circuit 19 selectively applies, between the lower electrode 2 and the upper electrode 5, a bias voltage such that the potential of the upper electrode 5 relative to the lower electrode 2 becomes a positive potential and a bias voltage such that the potential of the upper electrode 5 relative to the lower electrode 2 becomes a negative potential.

The voltage supply circuit 19 is not limited to a specific power source circuit, may be a circuit that generates a predetermined voltage, or may be a circuit that changes a voltage supplied from another power source to a predetermined voltage. The imaging device 100 need not include the voltage supply circuit 19. For example, a voltage may be supplied to the upper electrode 5 from an external power source.

The vertical scanning circuit 25 is connected to the address signal line 36 and the reset signal line 37, selects pixels 24 disposed in each row on a row-by-row basis, and performs readout of a signal voltage and resetting of the potential of the lower electrode 2. The power source wiring line 31, which is a source follower power source, supplies a predetermined power source voltage to each pixel 24. The horizontal signal readout circuit 20 is electrically connected to the column signal processing circuits 29. The column signal processing circuit 29 is electrically connected to the pixels 24 that are disposed in each column via the vertical signal line 27 corresponding to each column. The load circuit 28 is electrically connected to each vertical signal line 27. The load circuit 28 and the amplification transistor 21 form a source follower circuit.

The differential amplifiers 32 are provided to correspond to each column. An inverting input terminal of the differential amplifier 32 is connected to a corresponding vertical signal line 27. An output terminal of the differential amplifier 32 is connected to the pixel 24 via a feedback line 33 corresponding to each column.

The vertical scanning circuit 25 applies, via the address signal line 36, a row selection signal for controlling on and off of the address transistor 23 to the gate electrode 23G of the address transistor 23. Thus, a row to be read out is scanned and selected. A signal voltage is read out to the vertical signal line 27 from the pixel 24 in the selected row. The vertical scanning circuit 25 applies, via the reset signal line 37, a reset signal for controlling on and off of the reset transistor 22 to the gate electrode 22G of the reset transistor 22. Thus, a row of the pixel 24 to be reset is selected. The vertical signal line 27 transmits, to the column signal processing circuits 29, a signal voltage that has been read out from the pixel 24 selected by the vertical scanning circuit 25.

The column signal processing circuit 29 performs noise-reduction signal processing, which is typified by correlated double sampling, analog-to-digital conversion (AD conversion), and the like.

The horizontal signal readout circuit 20 sequentially reads out signals from the column signal processing circuits 29 to a horizontal common signal line.

The differential amplifier 32 is connected to the drain electrode of the reset transistor 22 via the feedback line 33. Accordingly, the differential amplifier 32 receives an output value of the address transistor 23 at the inverting input terminal. The differential amplifier 32 performs a feedback operation so that the gate potential of the amplification transistor 21 becomes a predetermined feedback voltage. At this time, the output voltage value of the differential amplifier 32 is, for example, 0 V or a positive voltage near 0 V. The term "feedback voltage" means the output voltage of the differential amplifier 32.

As illustrated in Fig. 5, the pixel 24 includes the semiconductor substrate 40, the charge detection circuit 35, the photoelectric converter 10A, and the charge accumulation node 34 (see Fig. 4).

The semiconductor substrate 40 may be an insulating substrate on which a semiconductor layer is provided on a surface thereof on a side on which a photosensitive region is formed, and may be, for example, a p-type silicon substrate. The semiconductor substrate 40 has impurity regions 21D, 21S, 22D, 22S, and 23S, and an element separation region 41 for electrical separation between the pixels 24. The impurity regions 21D, 21S, 22D, 22S, and 23S are, for example, n-type regions. Here, the element separation region 41 is provided between the impurity region 21D and the impurity region 22D. Thus, leakage of signal charges accumulated in the charge accumulation node 34 is suppressed. The element separation region 41 is formed, for example, by performing ion injection of an acceptor under a predetermined injection condition.

The impurity regions 21D, 21S, 22D, 22S, and 23S are, for example, dispersion regions formed in the semiconductor substrate 40. As illustrated in Fig. 5, the amplification transistor 21 includes the impurity region 21S, the impurity region 21D, and the gate electrode 21G. The impurity region 21S and the impurity region 21D respectively function as, for example, a source region and a drain region of the amplification transistor 21. A channel region of the amplification transistor 21 is formed between the impurity region 21S and the impurity region 21D.

Likewise, the address transistor 23 includes the impurity region 23S, the impurity region 21S, and the gate electrode 23G connected to the address signal line 36. In this example, the amplification transistor 21 and the address transistor 23 are electrically connected to each other by sharing the impurity region 21S. The impurity region 23S functions as, for example, a source region of the address transistor 23. The impurity region 23S has connection with the vertical signal line 27 illustrated in Fig. 4.

On the semiconductor substrate 40, an interlayer insulating layer 50 is stacked in such a way as to cover the amplification transistor 21, the address transistor 23, and the reset transistor 22. In Fig. 5, hatching that indicates the cross section of the interlayer insulating layer 50 is omitted for viewability.

A wiring layer (not shown) can be disposed in the interlayer insulating layer 50. The wiring layer is made from, for example, a metal such as copper, and can include, for example, wiring such as the aforementioned vertical signal line 27 in a part thereof. It is possible to set the number of insulating layers in the interlayer insulating layer 50 and the number of layers included in a wiring layer disposed in the interlayer insulating layer 50 to any appropriate number.

In the interlayer insulating layer 50, a contact plug 53 connected to the gate electrode 21G of the amplification transistor 21; a contact plug 54 connected to the impurity region 22D of the reset transistor 22; a contact plug 51 connected to the lower electrode 2; and wiring 52 that connects the contact plug 51, the contact plug 54, and the contact plug 53 are disposed. Thus, the impurity region 22D of the reset transistor 22 is electrically connected to the gate electrode 21G of the amplification transistor 21. In the configuration illustrated in Fig. 5, the contact plugs 51, 53, and 54, the wiring 52, the gate electrode 21G of the amplification transistor 21, and the impurity region 22D of the reset transistor 22 constitute at least a part of the charge accumulation node 34.

The charge detection circuit 35 detects signal charges collected by the lower electrode 2, and outputs a signal voltage. The charge detection circuit 35 includes the amplification transistor 21, the reset transistor 22, and the address transistor 23, and is formed in the semiconductor substrate 40.

The amplification transistor 21 is formed in the semiconductor substrate 40; and includes the impurity region 21D and the impurity region 21S that respectively function as a drain electrode and a source electrode, a gate insulating layer 21X formed on the semiconductor substrate 40, and the gate electrode 21G formed on the gate insulating layer 21X.

The reset transistor 22 is formed in the semiconductor substrate 40; and includes the impurity region 22D and the impurity region 22S that respectively function as a drain electrode and a source electrode, a gate insulating layer 22X formed on the semiconductor substrate 40, and the gate electrode 22G formed on the gate insulating layer 22X.

The address transistor 23 is formed in the semiconductor substrate 40; and includes the impurity regions 21S and 23S that respectively function as a drain electrode and a source electrode, a gate insulating layer 23X formed on the semiconductor substrate 40, and the gate electrode 23G formed on the gate insulating layer 23X. Through the impurity region 21S, the amplification transistor 21 and the address transistor 23 are connected in series.

The aforementioned photoelectric converter 10A is disposed on the interlayer insulating layer 50. In other words, in the present embodiment, the pixels 24 of the pixel array PA are formed on the semiconductor substrate 40. The pixels 24, which are arranged two-dimensionally on the semiconductor substrate 40, form a photosensitive region. The distance between two pixels 24 that are connected (that is, the pixel pitch) may be, for example, about 2 $\mu$m.

The charge blocking layer 3, the photoelectric conversion layer 4, and the upper electrode 5 are formed, for example, across multiple pixels 24. On the other hand, the lower electrode 2 is provided in each pixel 24, and is electrically separated from the lower electrode 2 of an adjacent pixel 24 by being spatially separated from the lower electrode 2 of the adjacent pixel 24. As described above, the upper electrode 5 has connection with the counter electrode signal line 26 connected to the voltage supply circuit 19. Accordingly, it is possible to simultaneously apply a voltage of a desirable magnitude between multiple pixels 24 from the voltage supply circuit 19 via the counter electrode signal line 26. As long as it is possible to apply a voltage of a desirable magnitude from the voltage supply circuit 19, the upper electrode 5 may be separately provided in each pixel 24. Likewise, the photoelectric conversion layer 4 and the charge blocking layer 3 may be separately provided in each pixel 24.

A color filter 60 is formed above the photoelectric converter 10A, and a microlens 61 is formed above the color filter 60. The color filter 60 is formed, for example, as an on-chip color filter by patterning, and a photosensitive resin or the like in which a dye or a pigment is dispersed is used as the material of the color filter 60. The microlens 61 is formed, for example, as an on-chip microlens, and an ultraviolet sensitive material or the like is used as the material of the microlens 61.

It is possible to use a general semiconductor manufacturing process to manufacture the imaging device 100. In particular, when a silicon substrate is used as the semiconductor substrate 40, it is possible to manufacture the imaging device 100 by using various silicon semiconductor processes.

[Operation of Imaging Device]

The imaging device 100 operates, for example, by using a global shutter method in which the exposure periods of the pixels 24 are the same. In the present specification, the term "exposure period" means a period for accumulating either electrons or holes generated by photoelectric conversion as signal charges in the charge accumulation node 34. In the present specification, the term "non-exposure period" refers to a period when the imaging device 100 is operating and that is not the exposure period. The "non-exposure period" may be a period when entry of light into the photoelectric converter 10A is blocked, or may be a period when the photoelectric converter 10A is irradiated with light but charges are not practically accumulated in the charge accumulation node 34. A readout operation of the imaging device 100 is not limited to an operation using a global shutter method, and any readout operation of known imaging devices can be used. For example, the imaging device 100 may operate by using a rolling shutter method with which signals are read out by exposing the pixels 24 to light sequentially from pixel column to pixel column. When the imaging device 100 operates by using a rolling shutter method, during imaging, the voltage supply circuit 19 continues to apply, to the upper electrode 5, a voltage such that the photoelectric converter 10A has sensitivity, and an operation of reading out signal charges is performed sequentially from pixel column to pixel column. That is, even in a period for performing a readout operation, the same bias voltage as in an exposure period described below is applied between the lower electrode 2 and the upper electrode 5.

In an operation using a global shutter method, for example, the voltage supply circuit 19 supplies, to the upper electrode 5, a voltage for performing imaging with desirable sensitivity in the exposure period, and supplies, to the upper electrode 5, a voltage such that the photoelectric converter 10A does not have sensitivity in the non-exposure period. Therefore, the photoelectric conversion efficiency of the pixels 24 in the exposure period is different from the photoelectric conversion efficiency of the pixels 24 in the non-exposure period, and, to be specific, is higher than the photoelectric conversion efficiency of the pixels 24 in the non-exposure period. In the exposure period, signal charges are accumulated in the charge accumulation node 34. In the non-exposure period, an operation of reading out signal charges accumulated in the charge accumulation node 34 in the exposure period is sequentially performed from pixel column to pixel column The expression "the photoelectric converter 10A does not have sensitivity" means that the photoelectric converter 10A does not practically have sensitivity. For example, the sensitivity of the photoelectric converter 10A in the non-exposure period is less than or equal to 5% of the sensitivity of the photoelectric converter 10A in the exposure period. The sensitivity of the photoelectric converter 10A in the non-exposure period may be less than equal to 1% of the sensitivity of the photoelectric converter 10A in the exposure period.

For example, in a first period that is an exposure period, the voltage supply circuit 19 supplies, to the upper electrode 5, a voltage such that a first bias voltage is applied between the lower electrode 2 and the upper electrode 5. For example, in a second period that is a non-exposure period, the voltage supply circuit 19 supplies, to the upper electrode 5, a voltage such that a second bias voltage is applied between the lower electrode 2 and the upper electrode 5. The photoelectric conversion layer 4 of the photoelectric converter 10A has photoelectric conversion sensitivity when the first bias voltage is applied between the lower electrode 2 and the upper electrode 5. Electrons and holes in the photoelectric conversion layer 4 recombine when the second bias voltage is applied between the lower electrode 2 and the upper electrode 5. The absolute value of the second bias voltage is, for example, less than the absolute value of the first bias voltage. The magnitude of a bias voltage applied between the lower electrode 2 and the upper electrode 5 changes also depending on the potential of the charge accumulation node 34, that is, the quantity of accumulated signal charges. The voltage supply circuit 19 selectively applies to the upper electrode 5, for example, a voltage such that the potential difference between the potential of the upper electrode 5 and the potential of the lower electrode 2 when the pixel 24 is reset becomes the first bias voltage and the second bias voltage. That is, in the present specification, the expression "the first bias voltage or the second bias voltage is applied between the lower electrode 2 and the upper electrode 5" means that a voltage such that the potential difference between the potential of the upper electrode 5 and the potential of the lower electrode 2 when the pixel 24 is reset becomes the first bias voltage or the second bias voltage is supplied to the upper electrode 5.

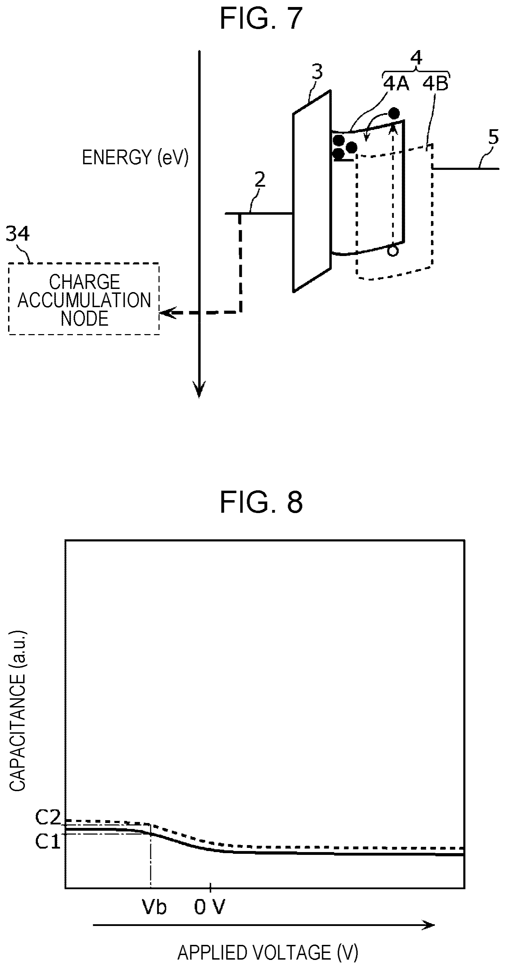

Fig. 6 is an exemplary energy band diagram of the photoelectric converter 10A when the first bias voltage is applied between the lower electrode 2 and the upper electrode 5. Fig. 7 is an exemplary energy band diagram of the photoelectric converter 10A when the second bias voltage is applied between the lower electrode 2 and the upper electrode 5. In Figs. 6 and 7, energy bands when the photoelectric converter 10A includes the photoelectric conversion element 10 is illustrated. In Figs. 6 and 7, electrons are indicated by black circles, holes are indicated by white circles, and some of the movements of electrons and holes are schematically illustrated.

For example, in an exposure period, when light enters the photoelectric converter 10A of the imaging device 100 and holes are accumulated in the charge accumulation node 34 as signal charges, as illustrated in Fig. 6, a first bias voltage with which the potential of the upper electrode 5 relative to the potential of the lower electrode 2 becomes a positive potential is applied between the lower electrode 2 and the upper electrode 5. Then, in the state illustrated in Fig. 6, pairs of electrons and holes are generated in the photoelectric conversion layer 4. Subsequently, because a potential higher than the potential of the lower electrode 2 is applied to the upper electrode 5, holes move to the lower electrode 2, electrons move to the upper electrode 5, and holes are accumulated in the charge accumulation node 34. That is, in the exposure period, signal charges in a quantity in accordance with the intensity of light with which the photoelectric converter 10A is irradiated are accumulated in the charge accumulation node 34. At this time, not all of the holes and electrons move to the lower electrode 2 and the upper electrode 5 and are extracted from the photoelectric converter 10A. Some of the holes and electrons are accumulated in the photoelectric converter 10A due to the influences of a trap level present in the photoelectric conversion layer 4, an interface between different materials, and the like. For example, Fig. 6 exemplarily illustrates a state in which holes are trapped in a trap level present in the photoelectric conversion layer 4. For an organic semiconductor material, the trap level is an intermediate level positioned between the energy level of HOMO and the energy level of LUMO, and traps electrons or holes. Charges trapped by a trap level are not limited to holes, and a trap level where electrons are trapped may be present in the photoelectric conversion layer 4. Although the donor semiconductor material 4A has a trap level in the example illustrated in Fig. 6, the acceptor semiconductor material 4B may have a trap level.

For example, when signal charges are to be read out in a non-exposure period after the aforementioned exposure period, as illustrated in Fig. 7, a second bias voltage with which the potential of the upper electrode 5 relative to the potential to the lower electrode 2 becomes a negative voltage is applied between the lower electrode 2 and the upper electrode 5. Then, in the state illustrated in Fig. 7, holes accumulated in the charge accumulation node 34 via the lower electrode 2 are read out. In the non-exposure period, the second bias voltage for suppressing movement of charges in the photoelectric converter 10A is applied between the lower electrode 2 and the upper electrode 5. Therefore, in a state in which the second bias voltage is applied, holes accumulated in the charge accumulation node 34 are not easily discharged to the lower electrode 2 and charges supplied from the voltage supply circuit 19 via the lower electrode 2 do not easily flow into the charge accumulation node 34. Therefore, in the non-exposure period, even when a readout operation is performed sequentially from row to row, the quantity of charges accumulated in the charge accumulation node 34 does not easily fluctuate during the readout operation.

Also at this time, in the same way as in the state illustrated in Fig. 6, when light enters the photoelectric converter 10A of the imaging device 100, pairs of electrons and holes are generated in the photoelectric conversion layer 4. In a non-exposure period, the generated holes and electrons cancel each other by recombination because movement of charges in the photoelectric converter 10A is suppressed by the second bias voltage. However, some of the holes and electrons are accumulated in the photoelectric converter 10A due to the influences of a trap level present in the photoelectric conversion layer 4, an interface between different materials, and the like. For example, Fig. 7 exemplarily illustrates a state in which electrons are trapped at a trap level present in the photoelectric conversion layer 4 and the interface between the photoelectric conversion layer 4 and the charge blocking layer 3. In the non-exposure period, because the second bias voltage for suppressing movement of charges is applied between the lower electrode 2 and the upper electrode 5, the quantity of charges accumulated in the photoelectric converter 10A is greater than that in the exposure period. Charges trapped at a trap level are not limited to holes, and a trap level where holes are trapped may be present in the photoelectric conversion layer 4. In the example illustrated in Fig. 6, the donor semiconductor material 4A has a trap level. However, the acceptor semiconductor material 4B may have a trap level.

In the state illustrated in Figs. 6 and 7, charges accumulate in the photoelectric converter 10A, and, as the quantity of accumulated charges increases, the dispersion of the quantity of charges increases. Because the photoelectric converter 10A is electrically connected to the charge accumulation node 34, the dispersion of the quantity of charges becomes a factor in generation of noise as a signal output of the imaging device 100. That is, it is possible to improve the S/N performance of the imaging device 100 by reducing the quantity of charges accumulated in the photoelectric converter 10A.

The quantity of charges accumulated in the photoelectric converter 10A is correlated to the capacitance of the photoelectric converter 10A described below. In a state in which electrons and holes are accumulated, electrostatic induction occurs more easily, that is, permittivity is higher than in a state in which electrons and holes are not accumulated. Thus, if the thickness of the photoelectric converter 10A is the same and the area of the electrode in plan view is the same, as the quantity of charges accumulated in the photoelectric converter 10A increases, the capacitance of the photoelectric converter 10A increases.

[Capacitance-Voltage Characteristics of Photoelectric Converter]

Next, the capacitance-voltage characteristics of the photoelectric converter 10A will be described.

Fig. 8 is a graph schematically illustrating an example of the capacitance-voltage characteristics (C-V characteristics) of the photoelectric converter 10A according to the present embodiment. In Fig. 8, the vertical axis represents the capacitance between the lower electrode 2 and the upper electrode 5, and the horizontal axis represents the voltage applied between the upper electrode 5 and the lower electrode 2.

In Fig. 8, the solid line indicates exemplary C-V characteristics of the photoelectric converter 10A in a state in which the photoelectric converter 10A is not irradiated with light. In Fig. 8, the broken line indicates exemplary C-V characteristics of the photoelectric converter 10A in a state in which the photoelectric converter 10A is irradiated with light and the photoelectric converter 10A is saturated with electrons and holes. Here, the expression "a state in which the photoelectric converter 10A is irradiated with light and the photoelectric converter 10A is saturated with electrons and holes" refers to a state in which the light intensity is increased and the value of the capacitance becomes constant. Usually, when the intensity of light with which the photoelectric converter 10A is irradiated is in a range of greater than or equal to 1000 lux, the value of the capacitance of the photoelectric converter 10A is constant. Therefore, the state in which the photoelectric converter 10A is saturated with electrons and holes is, for example, a state in which the photoelectric converter 10A is irradiated with light whose intensity is 1000 lux.

In Fig. 8, the C-V characteristics are indicated based on the definition that a voltage such that signal charges move to the lower electrode 2 is a "positive" voltage. That is, in Fig. 8, a voltage such that signal charges are collected by the lower electrode 2 is on the right side of the horizontal axis, and a voltage such that movement of signal charges to the lower electrode 2 is suppressed is on the left side of the horizontal axis. Therefore, when signal charges are holes, a voltage such that the potential of the upper electrode 5 becomes higher than the potential of the lower electrode 2 has a "positive" value. When signal charges are electrons, a voltage such that the potential of the upper electrode 5 becomes lower than the potential of the lower electrode 2 has a "positive" value.

As illustrated in Fig. 8, in the C-V characteristics of the photoelectric converter 10A according to the present embodiment, generally, the capacitance increases as the voltage applied between the lower electrode 2 and the upper electrode 5 is reduced. To be more specific, in the C-V characteristics of the photoelectric converter 10A, as the voltage applied between the lower electrode 2 and the upper electrode 5 is reduced from a positive high voltage, the capacitance stays constant before the voltage becomes a predetermined voltage, and the capacitance increases after the voltage becomes lower than the predetermined voltage. This is because movement of charges becomes restrained and it becomes easier for charges to be accumulated in the photoelectric converter 10A. As the voltage is reduced further from the predetermined voltage, the capacitance becomes constant again when the voltage becomes lower than equal to a predetermined negative voltage. The expression "the capacitance becomes constant" means that change in capacitance when voltage is changed by 1 V is less than or equal to 1% when the voltage is reduced or increased within a range such that the photoelectric converter 10A does not break. In the C-V characteristics of the photoelectric converter 10A, when the voltage is reduced further than the predetermined negative voltage, the potential difference between the lower electrode 2 and the upper electrode 5 increases and it becomes easier for charges accumulated in the photoelectric converter 10A to move to the electrode again, and thus the capacitance that has once increased may decrease.

The aforementioned first bias voltage is, for example, a voltage in a range such that the capacitance becomes constant when the voltage is increased in the C-V characteristics of the photoelectric converter 10A. The first bias voltage is, for example, greater than 0 V, and the absolute value of the first bias voltage is greater than the absolute value of the second bias voltage. The first bias voltage may be, for example, greater than or equal to 2 V or may be greater than or equal to 5 V. The first bias voltage may be, for example, less than or equal to 15 V.

The aforementioned second bias voltage is a voltage less than or equal to a voltage that forms an inflection point after the value has started to rise when the voltage is reduced in the C-V characteristics of the photoelectric converter 10A. The second bias voltage is, for example, a negative voltage less than 0 V. The second bias voltage may be less than or equal to -0.5 V, or may be less than or equal to -1 V. The second bias voltage may be greater than or equal to -5 V, or may be greater than or equal to -3 V.

These values of the first bias voltage and the second bias voltage are values when it is defined that a voltage such that signal charges move to the lower electrode 2 has a "positive" value as described above.

As illustrated in Fig. 8, the capacitance of the photoelectric converter 10A in a state in which the photoelectric converter 10A is irradiated with light is greater than the capacitance of the photoelectric converter 10A in a state in which the photoelectric converter 10A is not irradiated with light. This is because, as described above with reference to Figs. 6 and 7, some of the charges generated by the photoelectric converter 10A due to irradiation with light are accumulated in the photoelectric converter 10A. That is, change in capacitance due to irradiation of the photoelectric converter 10A with light corresponds to change in the quantity of charges accumulated in the photoelectric converter 10A, and, as the quantity of charges accumulated in the photoelectric converter 10A increases, the capacitance of the photoelectric converter 10A increases. The capacitance of the photoelectric converter 10A is the average value of capacitances that are obtained by measuring impedances at alternating-current frequencies from 10 Hz to 10 kHz by using an impedance measuring device such as an LCR meter connected to the lower electrode 2 and the upper electrode 5. The capacitance of the photoelectric converter 10A is measured, for example, collectively for multiple pixels 24, and is calculated as a value for the photoelectric converter 10A of one pixel 24. The capacitance of the photoelectric converter 10A may be measured, by dividing the imaging device 100, for pixel blocks each having one pixel 24 or two or more pixels 24.

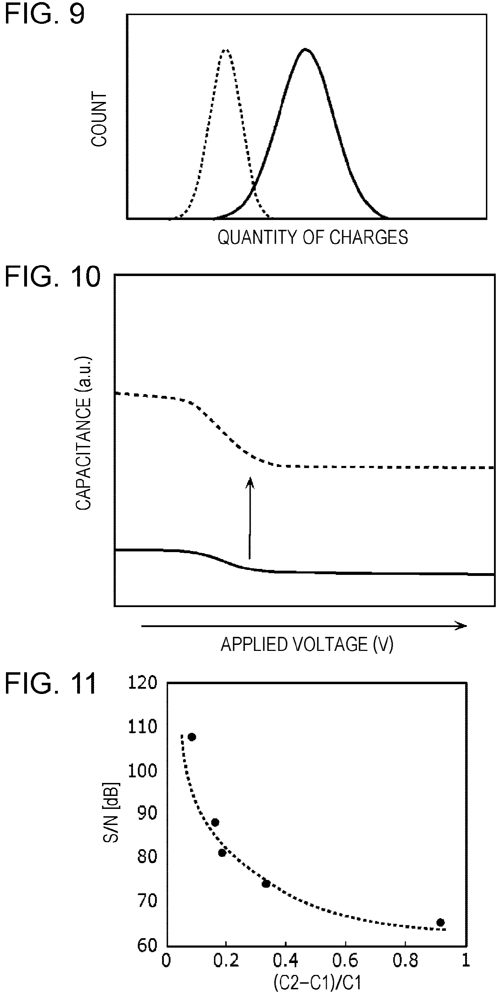

Fig. 9 is a graph conceptually illustrating the distribution of the quantity of charges accumulated in the photoelectric converter 10A. In Fig. 9, the horizontal axis represents the quantity of charges accumulated in the photoelectric converter 10A. In Fig. 9, the vertical axis represents one of the followings: the number of photoelectric converters 10A in which charges in the quantity represented by the horizontal axis are accumulated when the charges are accumulated in the photoelectric converters 10A under the same conditions; and the number of times charges in the quantity represented by the horizontal axis are accumulated in the photoelectric converter 10A when charges are accumulated in the photoelectric converter 10A multiple times at regular intervals under the same conditions.

In Fig. 9, the solid line exemplarily illustrates the distribution when the quantity of charges accumulated in the photoelectric converter 10A is large. In Fig. 9, the broken line exemplarily illustrates the distribution when the quantity of charges accumulated in the photoelectric converter 10A is small. As illustrated in Fig. 9, the dispersion of the quantity of charges accumulated in the photoelectric converter 10A changes depending on the quantity of charges. Therefore, when the quantity of charges accumulated in the photoelectric converter 10A is small, the dispersion of the quantity of charges accumulated in the photoelectric converter 10A is small. Thus, it is possible to reduce the influence of the quantity of charges accumulated in the photoelectric converter 10A on the charge accumulation node 34 electrically connected to the photoelectric converter 10A, noise in the imaging device 100 can be reduced, and the S/N performance improves.

Because the quantity of charges in the photoelectric converter 10A depends on the capacitance of the photoelectric converter 10A, as illustrated in Fig. 8, by suppressing increase in the capacitance of the photoelectric converter 10A due to irradiation of the photoelectric converter 10A with light, it is possible to improve the S/N performance of the imaging device 100. To be specific, in the imaging device 100 according to the present embodiment, when a predetermined bias voltage Vb is applied between the lower electrode 2 and the upper electrode 5, $(C2 - C1)/C1 \leq 0.2$ is satisfied, where C1 is the capacitance of the photoelectric converter 10A in a state in which the photoelectric converter 10A is not irradiated with light, and C2 the capacitance of the photoelectric converter 10A in a state in which the photoelectric converter 10A is irradiated with light and the photoelectric converter 10A is saturated with electrons and holes. Thus, it is possible to suppress accumulation of charges in the photoelectric converter 10A, to reduce noise in the imaging device 100, and to improve the S/N performance. In view of further improvement of the S/N performance, $(C2 - C1)/C1 \leq 0.1$ may be satisfied, or $(C2 - C1)/C1 \leq 0.05$ may be satisfied in the imaging device 100.

The predetermined bias voltage Vb is, for example, a voltage that is applied between the lower electrode 2 and the upper electrode 5 when the charge detection circuit 35 detects signal charges, that is, when a signal voltage is read out from the pixel 24 to the vertical signal line 27. Thus, the quantity of charges accumulated in the photoelectric converter 10A decreases when signals are read out, and noise can be reduced. When the imaging device 100 operates by using a global shutter method, the predetermined bias voltage Vb is, for example, the aforementioned second bias voltage. When the imaging device 100 operates by using a rolling shutter method, the predetermined bias voltage Vb is, for example, the aforementioned first bias voltage.

Fig. 10 is a graph schematically illustrating an example of the capacitance-voltage characteristics (C-V characteristics) of a photoelectric converter according to Comparative Example. As in Fig. 8, in Fig. 10, the solid line indicates the exemplary C-V characteristics of the photoelectric converter in a state in which the photoelectric converter is not irradiated with light. In Fig. 10, the broken line indicates the exemplary C-V characteristics of the photoelectric converter in a state in which the photoelectric converter is irradiated with light and the photoelectric converter is saturated with electrons and holes. As illustrated in Fig. 10, in the photoelectric converter according to Comparative Example, due to the influences of a trap level and the like, charges accumulate in the photoelectric converter and the capacitance increases considerably when the photoelectric converter is irradiated with light. Therefore, the quantity of charges accumulated in the photoelectric converter increases, and the dispersion of the quantity of charges accumulated in the photoelectric converter is large. Thus, an imaging device using the photoelectric converter according Comparative Example has low S/N.

Any method may be used to suppress increase in the capacitance of the photoelectric converter 10A due to irradiation with light, as long as the method can suppress accumulation of charges in the photoelectric converter 10A due to the aforementioned mechanism. For example, as described above, when an ITO film is used as the upper electrode 5, it is possible to reduce trap levels in the photoelectric conversion layer 4 by forming the ITO film by using a deposition gas in which the oxygen concentration is less than or equal to 0.12%, and thus accumulation of charges in the photoelectric converter 10A can be suppressed.

Next, referring to Fig. 4, the saturation signal quantity of the imaging device 100 and the dynamic range, which is the ratio of the saturation signal quantity to noise, will be described. Here, a case where holes are used as signal charges will be described.

In Fig. 4, as described above, holes generated in the photoelectric converter 10A are accumulated in the charge accumulation node 34. As holes are accumulated, the potential of the charge accumulation node 34 rises. That is, in this case, the maximum potential corresponding to the quantity of charges that the charge accumulation node 34 can hold is the saturation signal quantity in the imaging device 100. In general, a voltage amplitude of about 3 V in the charge accumulation node 34, which corresponds to the gate voltage of the amplification transistor 21, is allowed. In this case, for example, when noise of 6 e⁻ is generated in an imaging device whose conversion gain is 50 $\mu$V/e⁻, a dynamic range of 80 dB, which corresponds to that of human eye, can be reliably obtained. In the imaging device 100 according to the present embodiment, even in a state in which the photoelectric converter 10A is irradiated with light, the quantity of charges accumulated in the photoelectric converter 10A is small and noise is reduced, and thus it is possible to realize wide dynamic range.

EXAMPLES

Hereafter, an imaging device according to the present disclosure will be specifically described by using Examples. The present disclosure is not limited to the following Examples. To be specific, photoelectric conversion elements to be included in an imaging device according to the present disclosure and photoelectric conversion elements for characteristics comparison were made, and the capacitance was measured. In addition, imaging devices according to the present disclosure and imaging devices for characteristics comparison were made, and the noise was measured.

(Making of Photoelectric Conversion Element)

Photoelectric conversion elements according to Examples and Comparative Example were made.

[Example 1]

TiN was used as the lower electrode 2, and the charge blocking layer 3 was formed by depositing 9,9'-[1,1'-Biphenyl]-4,4'-diylbis[3,6-bis (1,1-dimethylethyl)]-9H-carbazole on the lower electrode 2 by vacuum vapor deposition. The thickness of the charge blocking layer 3 obtained at this time was 50 nm.

Next, the photoelectric conversion layer 4 was formed on the charge blocking layer 3 by vacuum-vapor co-depositing subphthalocyanine, which is a donor semiconductor material, and fullerene C60, which is an acceptor semiconductor material, as materials of the photoelectric conversion layer 4. The weight ratio of the donor semiconductor material to the acceptor semiconductor material was 1:3. The thickness of the photoelectric conversion layer 4 obtained at this time was 400 nm. As the subphthalocyanine, subphthalocyanine that had boron (B) as the central metal and in which a chloride ion was coordinated to B as a ligand was used.

Next, on the photoelectric conversion layer 4, an ITO film was formed as the upper electrode 5 with a film thickness of 50 nm by sputtering. To adjust the ITO film deposition atmosphere, a deposition gas in which argon and oxygen were mixed was introduced into a chamber, and the pressure in the chamber was adjusted to 0.3 Pa. At this time, the oxygen concentration in the deposition gas was 0.12%.

Subsequently, by forming an $Al_2O_3$ film as a sealing film on the upper electrode 5 by atomic layer deposition, a photoelectric conversion element according to Example 1 was obtained.

[Example 2]

Except that the oxygen concentration in the deposition gas was 0.04% in forming an ITO film, steps similar to those of Example 1 were performed, and a photoelectric conversion element according to Example 2 was obtained.

[Example 3]

Except that the oxygen concentration in the deposition gas was 0% in forming an ITO film, that is, a deposition gas including only argon was used, steps similar to those of Example 1 were performed, and a photoelectric conversion element according to Example 3 was obtained.

[Comparative Example 1]

Except that the oxygen concentration in the deposition gas was 0.18% in forming an ITO film, steps similar to those of Example 1 were performed, and a photoelectric conversion element according to Comparative Example 1 was obtained.

[Comparative Example 2]

Except that the oxygen concentration in the deposition gas was 0.23% in forming an ITO film, steps similar to those of Example 1 were performed, and a photoelectric conversion element according to Comparative Example 2 was obtained.

(Measurement of Capacitance)

The capacitance of each of the photoelectric conversion elements according to Examples and Comparative Examples was measured.

In measurement of the capacitance of the photoelectric conversion element, the impedances of the photoelectric conversion element at alternating-current frequencies from 10 Hz to 10 kHz were measured by using an LCR meter (E4980A made by Keysight Technologies, Inc.) connected to the lower electrode 2 and the upper electrode 5, and the average value of the capacitances at the frequencies was calculated. During the measurement, a bias voltage of -1 V was applied between the lower electrode 2 and the upper electrode 5. The capacitance was measured in a state in which the photoelectric conversion element was not irradiated with light and in a state in which photoelectric conversion element was irradiated with light of 1000 lux, the capacitance of the photoelectric conversion element in the state in which the photoelectric conversion element was not irradiated with light was denoted by C1, and the capacitance of the photoelectric conversion element in the state in which the photoelectric conversion element was irradiated with light of 1000 lux was denoted by C2. Even when the intensity of light with which the photoelectric conversion element was irradiated was made greater than or equal to 1000 lux, the capacitance of the photoelectric conversion element was approximately the same as the capacitance C2. That is, the measured capacitance C2 was the capacitance of the photoelectric conversion element when the photoelectric conversion element was irradiated with light and the photoelectric conversion element was saturated with electrons and holes.

(C2 - C1)/C1 was less than or equal to 0.2 in the photoelectric conversion elements according to Examples 1 to 3, and (C2 - C1)/C1 was greater than 0.2 in the photoelectric conversion elements according to Comparative Examples 1 and 2.

(Making of Imaging Device)

By using a photoelectric conversion element having the same configuration as the photoelectric conversion element according to Example 1 as the photoelectric converter of each pixel 24, the charge detection circuit 35 connected to the lower electrode 2 via the charge accumulation node 34 was formed, and an imaging device according to Example 1 was made. Also regarding photoelectric conversion elements according to Examples 2 and 3 and Comparative Examples 1 and 2, as with Example 1, by using a photoelectric conversion element having the same configuration as the photoelectric converter of each pixel 24, imaging devices according to Examples 2 and 3 and Comparative Examples 1 and 2 were made.

(Measurement of S/N)

The S/N of the imaging devices according to Examples and Comparative Examples was measured. In measurement of the S/N, in a state in which the photoelectric converter was irradiated with light of 1000 lux, the potential of the charge accumulation node 34 of each pixel 24 was reset and then a bias voltage of 10 V was applied between the lower electrode 2 and the upper electrode 5 for a predetermined period, and an output detected by the charge detection circuit 35 after a predetermined period has passed was obtained. Then, the average value of the outputs from the pixels 24 was calculated as a signal value. This value was basically an output value corresponding to the saturation electron quantity of the charge accumulation node 34. Next, in a state in which the photoelectric converter was not irradiated with light, the potential of the charge accumulation node 34 of each pixel 24 was reset and then a bias voltage of 10 V was applied between the lower electrode 2 and the upper electrode 5 for a predetermined period, and an output detected by the charge detection circuit 35 after a predetermined period had passed was obtained multiple times. Then, the standard deviation of the outputs from the pixels 24 was calculated as a noise value. Lastly, the S/N was obtained as a value calculated by using a mathematical expression 20log10(signal value/-noise value).

Fig. 11 is a graph illustrating the relationship between (C2 - C1)/C1 and the S/N of imaging devices according to Examples and Comparative Examples. In Fig. 11, the vertical axis represents the S/N. In Fig. 11, the horizontal axis represents (C2 - C1)/C1. The black dots in Fig. 11 correspond to, in descending order of the S/N, the results of measuring the S/N of the imaging devices according to Example 3, Example 2, Example 1, Comparative Example 1, and Comparative Example 2.

As illustrated in Fig. 11, it can be seen that, with an imaging device in which (C2 - C1)/C1 ≤ 0.2 is satisfied, decrease of the S/N of the imaging device is suppressed and it is possible to realize a wide dynamic range of greater than or equal to 80 dB, which corresponds to that of human eye.

In this way, with an imaging device according to the present disclosure, because (C2 - C1)/C1 ≤ 0.2 is satisfied as in the imaging devices according to Examples 1 o 3, an imaging device whose S/N performance is improved has be realized. This is because, as described above, since the quantity of charges accumulated in the photoelectric converter is small even in a state in which the photoelectric converter is irradiated with light, it is possible to reduce the influence of the dispersion of the quantity of charges accumulated in the photoelectric converter on the charge accumulation node 34 electrically connected to the photoelectric converter.

Heretofore, an imaging device according to the present disclosure has been described based on embodiments and Examples. However, the present disclosure is not limited to these embodiments and Examples. Without departing from the gist of the present disclosure, the scope of the present disclosure includes configurations in which various modifications that a person having ordinary skill in the art can conceive are made on the embodiments and Examples and other configurations that are constructed by combining some of the constituent elements of the embodiments and Examples.

Industrial Applicability

An imaging device according to the present disclosure is applicable to various camera systems, such as a medical camera, a monitor camera, a car-mounted camera, a distance measurement camera, a microscope camera, a drone camera, and a robot camera, and sensor systems.

Reference Signs List

1 support substrate
2 lower electrode
3,6 charge blocking layer
4 photoelectric conversion layer
4A doner semiconductor material
4B acceptor semiconductor material
5 upper electrode
10, 11 photoelectric conversion element
10A photoelectric converter
19 voltage supply circuit
20 horizontal signal readout circuit
21 amplification transistor
22 reset transistor
23 address transistor
21D, 21S, 22D, 22S, 23S impurity region
21G, 22G, 23G gate electrode
21X, 22X, 23X gate insulating layer
24 pixel
25 vertical scanning circuit
26 counter electrode signal line
27 vertical signal line
28 load circuit
29 column signal processing circuit
31 power source wiring line
32 differential amplifier
33 feedback line
34 charge accumulation node
35 charge detection circuit
36 address signal line
37 reset signal line
40 semiconductor substrate
41 element separation region
50 interlayer insulating layer
51, 53, 54 contact plug
52 wiring
60 color filter
61 microlens
100 imaging device

**Claims**

1. An imaging device comprising:

    pixels,
    wherein each of the pixels includes a photoelectric conversion element and a charge accumulation region,
    wherein the photoelectric conversion element includes

        a first electrode,
        a second electrode that is disposed to face the first electrode, and

a photoelectric conversion layer that is positioned between the first electrode and the second electrode, includes a donor semiconductor material and an acceptor semiconductor material, and generates electrons and holes by absorbing light,

wherein the charge accumulation region is electrically connected to the first electrode and accumulates signal charges that are either the electrons or the holes, and
wherein, when a predetermined bias voltage is applied between the first electrode and the second electrode,

$$(C2 - C1)/C1 \leq 0.2$$

is satisfied,
where C1 is a capacitance of the photoelectric conversion element in a state in which the photoelectric conversion element is not irradiated with light, and C2 is the capacitance of the photoelectric conversion element in a state in which the photoelectric conversion element is irradiated with light and the photoelectric conversion element is saturated with the electrons and the holes.

2. The imaging device according to claim 1,
wherein, between the first electrode and the second electrode, a first bias voltage is applied in a first period that is an exposure period and a second bias voltage that is different from the first bias voltage is applied in a second period that is a non-exposure period.

3. The imaging device according to claim 2,
wherein a photoelectric conversion efficiency of the photoelectric conversion element in the first period is different from the photoelectric conversion efficiency of the photoelectric conversion element in the second period.

4. The imaging device according to claim 2,

wherein the imaging device operates by using a global shutter method in which all exposure periods of the pixels are the same, and
wherein the first period is a period for accumulating the signal charges in the charge accumulation region.

5. The imaging device according to claim 4,
wherein the electrons and the holes in the photoelectric conversion layer recombine when the second bias voltage is applied between the first electrode and the second electrode.

6. The imaging device according to claim 4,
wherein the photoelectric conversion layer has photoelectric conversion sensitivity when the first bias voltage is applied between the first electrode and the second electrode.

7. The imaging device according to claim 1, further comprising:
a voltage supply circuit that selectively applies, between the first electrode and the second electrode, a bias voltage such that a potential of the second electrode relative to the first electrode becomes a positive potential and a bias voltage such that the potential of the second electrode relative to the first electrode becomes a negative potential.

8. The imaging device according to any one of claims 1 to 7,
wherein the photoelectric conversion element further includes a first charge blocking layer that is positioned between the first electrode and the photoelectric conversion layer.

9. The imaging device according to claim 8,
wherein a thickness of the first charge blocking layer is greater than or equal to 10 nm.

10. The imaging device according to any one of claims 1 to 7,
wherein the photoelectric conversion element further includes a second charge blocking layer that is positioned between the second electrode and the photoelectric conversion layer.

11. The imaging device according to claim 10,
wherein a thickness of the second charge blocking layer is greater than or equal to 5 nm.

# FIG. 1

# FIG. 2

# FIG. 3

# FIG. 4

# FIG. 5

# FIG. 6

# FIG. 7

# FIG. 8

FIG. 9

FIG. 10

FIG. 11

## INTERNATIONAL SEARCH REPORT

International application No.

**PCT/JP2024/008995**

### A. CLASSIFICATION OF SUBJECT MATTER

*H01L 27/146*(2006.01)i; *H04N 25/70*(2023.01)i; *H10K 30/20*(2023.01)i; *H10K 30/60*(2023.01)i; *H10K 39/32*(2023.01)i
FI:  H01L27/146 E; H10K30/20; H10K30/60; H04N25/70; H10K39/32

According to International Patent Classification (IPC) or to both national classification and IPC

### B. FIELDS SEARCHED

Minimum documentation searched (classification system followed by classification symbols)

H01L27/146; H04N25/70; H10K30/20; H10K30/60; H10K39/32

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2021/220820 A1 (PANASONIC INTELLECTUAL PROPERTY MANAGEMENT CO., LTD.) 04 November 2021 (2021-11-04) | 1-11 |
| A | WO 2020/162095 A1 (PANASONIC INTELLECTUAL PROPERTY MANAGEMENT CO., LTD.) 13 August 2020 (2020-08-13) | 1-11 |
| A | WO 2017/081831 A1 (PANASONIC INTELLECTUAL PROPERTY MANAGEMENT CO., LTD.) 18 May 2017 (2017-05-18) | 1-11 |
| A | JP 2006-319441 A (SHARP KABUSHIKI KAISHA) 24 November 2006 (2006-11-24) | 1-11 |

☐ Further documents are listed in the continuation of Box C. ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **10 May 2024** | **21 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

| | International application No. |
|---|---|
| | **PCT/JP2024/008995** |

| Patent document cited in search report | | | Publication date (day/month/year) | Patent family member(s) | | | Publication date (day/month/year) |
|---|---|---|---|---|---|---|---|
| WO | 2021/220820 | A1 | 04 November 2021 | US | 2023/0045630 | A1 | |
| | | | | EP | 4145542 | A1 | |
| | | | | CN | 115398626 | A | |
| WO | 2020/162095 | A1 | 13 August 2020 | US | 2021/0359005 | A1 | |
| | | | | EP | 3923361 | A1 | |
| | | | | CN | 113016089 | A | |
| WO | 2017/081831 | A1 | 18 May 2017 | US | 2018/0219047 | A1 | |
| | | | | EP | 3376543 | A1 | |
| | | | | CN | 107851652 | A | |
| JP | 2006-319441 | A | 24 November 2006 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007311647 A

- JP 2012094660 A